# EUROPEAN PATENT SPECIFICATION

(11) **EP 0 404 240 B1**
(45) Date of publication and mention of the grant of the patent: **30.03.1994**
(21) Application number: 90201564.3
(22) Date of filing: 15.06.1990
(51) Int. Cl.: F16B 5/06, H05K 5/03, H02B 1/30

(54) **Snap connection system, in particular for electrical installation cabinets**
Schnappverbindungsanordnung, insbesondere für elektrische Schaltschränke
Système de liaison encliquetable, en particulier pour armoires d'installations électriques

(30) Priority: 19.06.1989 NL 8901539
(43) Date of publication of application: 27.12.1990
(73) Proprietor: HOLEC SYSTEMEN EN COMPONENTEN B.V., NL-7555 CS Hengelo (NL)
(72) Inventor: Postmus, Albert Jozef Peter, NL-7443 GN Nijverdal (NL); Hoekstra, Jan Willem, NL-7558 EP Hengelo (NL); Wensink, Jan Bertus, NL-7496 AJ Hengevelde (NL)
(74) Representative: de Bruijn, Leendert C.

(56) References cited:
- DE-A- 3 035 669

## Description

The invention relates to a snap connection system for detachably connecting a detachable part of an assembly to a fixed part thereof, in particular for detachably fixing a cover on a housing for electrical installations, which connection system contains at least one set of connecting elements, of which one is fitted on the detachable part of the assembly, and the other on the fixed part, and one being provided with a lobe part and the other with a catch part interacting therewith to produce a connection, the connecting element provided with a lobe part being movable resiliently in one direction and being rigid in the directions at right angles thereto, all this in such a way that during the fitting of the detachable part on the fixed part of the assembly the connecting element provided with a lobe part is moved away in its resilient direction of movement by the connecting element provided with a catch part, through movement of the lobe part along the catch part, and is then moved back resiliently into the locked position after the lobe part has been moved until it is past the catch part.

Dutch Patent Application 8701200 (corresponding to EP-A-293035), which has been laid open for inspection, describes a snap connection of the type described above. In the case of this known connection system, when the cover is being fitted on the housing, the resilient lip-shaped connecting element provided with a lobe is first pressed outwards by a rigid connecting element which is provided with a catch and fixed in the housing until the lobe part can spring back and engages behind the catch part, so that the cover is firmly locked on the housing. In order to be able to remove the cover subsequently from the housing again, the resilient connecting element of the cover has to be bent back and can then be moved again along the catch in the housing. In order to ensure that on the release of one set of connecting elements the lobe and the catch in another set of connecting elements do not engage with each other again through the connecting element provided with the lobe part on the cover springing back, in the known connection system a second hook-shaped part is fitted on the housing in order to ensure that the resilient, bent back connecting element provided with a lobe part is retained on the cover in the bent back position during removal of the cover, as long as the cover is not removed entirely from the housing.

Although a reliable connection can be achieved quickly in this way without tools simply by pressing the cover on the housing, this known snap connection still has a number of disadvantages.

One disadvantage is that a separate locking element has to be fitted for blocking the resilient connecting element in the unlocked position when the cover is removed. Another disadvantage is that the resilient connecting element has to be bent away at a place which, from the point of view of the operating person, faces away from the "hinge point" of the resilient element. Since the last-mentioned point is rigid, this situation impedes the movement for proper unlocking of the connection. A levering movement has to be made here for the unlocking movement, which particularly increases the risk of damage to the cover and the snap connection. This unlocking movement is also impeded by the adjacent cabinet when several cabinets are placed next to each other.

DE-A-3,035,669 discloses also a snap connection system, containing at least one set of connecting elements, one of which being fitted on a detachable part of an assembly and the other being fitted on a fixed part thereof. One of the connecting elements is formed as an immovable, fixed catch member, whereas the other element is provided with a lobe part and is resilient in two different directions. However, providing a connecting element resilient in two directions is disadvantageous from a design point of view.

The object of the invention is to eliminate the above-mentioned disadvantages and to provide a detachable connection system which is simpler and allows the greatest possible freedom in design.

The above-mentioned objects are achieved according to the invention in that the connecting element provided with the catch part is also movable resiliently in a direction at right angles to the direction in which the connecting element provided with the lobe part is movable and in the directions at right angles thereto is rigid, in such a way that the connecting element provided with the catch part is movable resiliently from a locked position, in which the catch part is locked with the lobe part of the connecting element provided with the lobe part, to an unlocked position in which the catch part lies totally clear of the lobe part, while provisions are made for blocking the connecting element provided with the catch part in the unlocked position thereof by the connecting element provided with the lobe part, until the latter element is removed from the former element, the connecting elements being rigid in the approaching and receding direction of the element provided with the lobe part.

With the snap connection system according to the invention, no separate blocking element is needed for blocking the connecting element provided with a lobe part on the cover in its unlocked position when the cover is removed. The blocking in the unlocked position is now achieved through the fact that the two connecting elements are made resilient and are positioned in such a way relative to each other that when the catch part is bent away from the locked position to the unlocked position, the connecting element provided with the lobe part itself starts to act as a blocking element.

An expedient embodiment of the connection system according to the invention is achieved through the fact that the catch part of one connecting element and the face of the body of the other connecting element against which said catch part lies in the locked position of the connecting elements are formed and/or positioned in such a way that when there is a resilient movement of the catch part from the locked position, the connecting element provided with the lobe part is moved resiliently in the direction away from the connecting element provided with the catch part, and in the fully unlocked position of the catch part moves back again resiliently to a position in which it blocks the connecting element provided with the catch part in the unlocked position.

The snap connection system according to the invention provides a great measure of freedom in design.

For example, it is possible to make the connecting elements lip-shaped, in which case these elements are then composed of resilient, bendable material, the lip-shaped elements each being fixed by one end to the part of the assembly in which they are fitted, and the element connected to the detachable part of the assembly at the free, bendable end thereof being provided with a lobe part, while the element connected to the fixed part at the bendable end thereof is provided with a catch part, the ends of the connecting elements provided with the lobe part and the catch part facing each other, and the lips being disposed in such a way that said ends are resiliently bendable in directions at right angles to each other and are not bendable in the directions at right angles thereto. In this case it is possible to make the connection such that the lip-shaped connecting elements are positioned essentially with their lengthwise directions at right angles to each other, in such a way that the connecting element provided with the catch part and disposed in the fixed part of the assembly is rigid in the approaching and receding direction of the connecting element provided with the lobe part, and the connecting element provided with the lobe part and fitted in the detachable part of the assembly is rigid in the resilient bending direction of the connecting element provided with the catch part.

According to another possibility, the connection system can be designed in such a way that the lip-shaped elements lie essentially with their lengthwise direction both in line with each other and in the approaching and receding direction of the connecting elements, while the connecting element provided with the catch part and fitted in the fixed part of the assembly is bendable in a plane parallel to the plane in which the longitudinal axis of the connecting element provided with the lobe part extends, and the connecting element provided with the lobe part is rigid in that bending direction.

Another expedient embodiment is obtained through the fact that the catch part of the connecting element provided with the catch part and the surface of the body of the connecting element provided with the lobe part against which the catch part lies in the locked position are at least partially bevelled, in such a way that on bending of the connecting element provided with the catch part in the transverse direction of the connecting element provided with the lobe part the connecting element provided with the lobe part is bent away.

The snap connection system according to the invention thus provides the possibility of bringing about the unlocking in a simple manner. For this, all that is necessary is to provide a slit-shaped hole in the cover, through which the connecting element provided with the catch part can be moved, e.g. by means of a screwdriver, in the unlocking direction.

Since the connecting element provided with the catch part is directed towards the operating person, no levering movement need be made, and no obstruction from adjacent cabinets is encountered.

In order to meet requirements as regards sealing or the like, the connecting element provided with the catch part can be designed in such a way that the slit-shaped hole in the cover required for the unlocking is always shut off.

The invention will now be explained in greater detail with reference to the drawing, in which by way of example a number of embodiments of the snap connection system according to the invention are shown in principle.

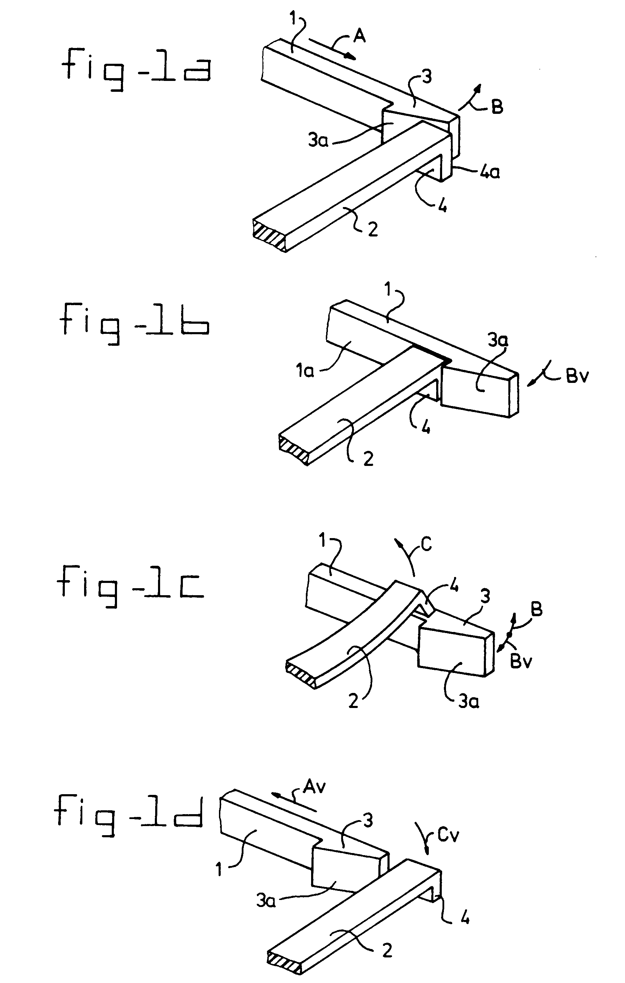

Fig. 1 shows in perspective view a set of connecting elements of a snap connection system according to the invention, which are made lip-shaped and are positioned with their lengthwise directions at right angles to each other. Figs. 1a, 1b, 1c and 1d show in succession the positions of the connecting elements during the making and releasing again of the connection.

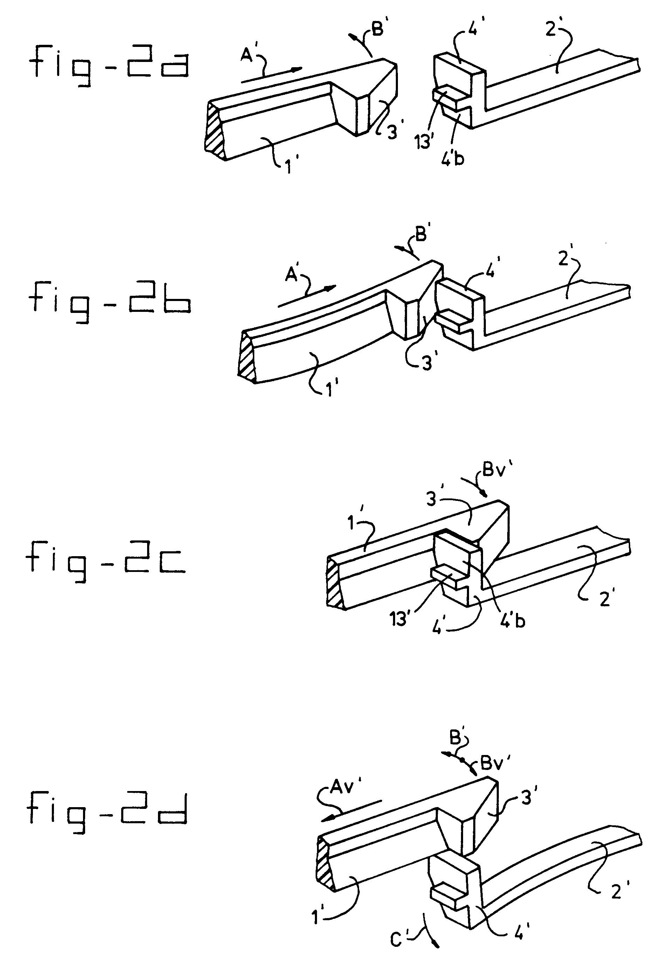

Fig. 2 shows a perspective view of a set of connecting elements of a snap connection system, which in this case also are made lip-shaped, but lie with their lengthwise directions in line with each other. Figs. 2a, 2b, 2c and 2d show in succession the positions of the connecting elements relative to each other during the making and releasing again of the connection.

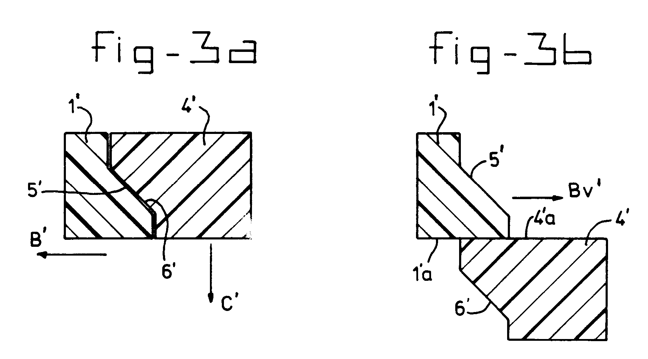

Fig. 3 shows schematically a cross-section of the connecting elements according to Fig. 2, Fig. 3a showing a cross-section in the position of the connecting elements shown in Fig. 2c, and Fig. 3b in the position of said connecting elements shown in Fig. 2d.

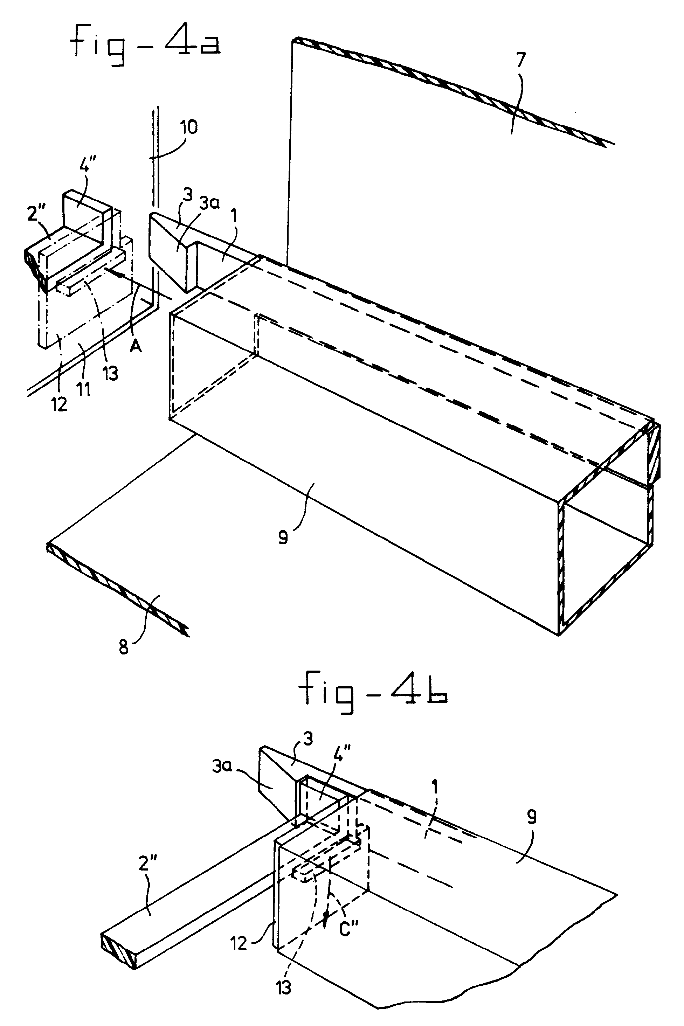

Fig. 4a shows in perspective a possible modified embodiment of the snap connection system of the principle according to Figs. 1a to 1d, with an indication there of the situation thereof in a cover and a cabinet in the position not yet snapped into place.

Fig. 4 shows a perspective view of the system according to Fig. 4a in the position snapped into place.

Fig. 1 shows a lip-shaped connecting element 1 which at one end is provided with a lobe 3, which connecting element 1 can be fixed by its end facing away from the lobe to a cover of a housing for an electrical installation. The lobe 3 is resiliently bendable in the direction of the arrow B. Fig. 1 also shows the other lip-shaped connecting element 2 of the connection system according to the invention, which lip-shaped element is provided at one end with a catch part 4, while the lip-shaped element is fixed by its other end to a housing for an electrical installation. The lip 2 is resiliently bendable in the direction of the arrow C, as indicated in Fig. 1c. The lips 1 and 2 are positioned with their lengthwise directions at right angles to each other and in the initial position are positioned in such a way that the catch part 4 rests with its surface 4a facing the lip 1 against the lobe 3. When the cover to which the connecting element 1 is connected is being fitted, the connecting element 1 is moved in the direction of the arrow A, in which case through the interaction of the catch surface 4a and the slanting lobe surface 3a the connecting element 1 is bent away in the direction of the arrow B, until the lobe 3 is moved past the catch 4, following which the connecting element 1 is moved resiliently again in the direction of the arrow Bv, as shown in Fig. 1b. In the position then reached, shown in Fig. 1b, the catch 4 rests against the surface 1a of the body of the connecting element 1 which has then returned to the rest position, while the catch part 4 and the lobe part 3 ensure that the cover is locked. If the cover to which the connecting element 1 is connected needs to be removed, the connecting element 2 is bent away, for example by means of a screwdriver, in the direction of the arrow C, as indicated in Fig. 1c. Due to the fact that the catch part 4 makes a circular movement, the connecting element 1 is bent away here in the direction of the arrow B, as indicated in Fig. 1c, until the catch 4 of the connecting element 2 has come entirely above the connecting element 1, in which position the connecting element 1 is moved resiliently back again in the direction of the arrow Bv in Fig. 1c, following which the position shown in Fig. 1c is reached. In this position the catch 4 is fully clear of the lobe part 3, while the connecting element 2 is blocked by the connecting element 1 in this position, a situation shown in Fig. 1c. The lobe part can then be removed freely in the direction of the arrow Av in Fig. 1d; when the lobe 3 is pushed through in its entirety under the catch 4, the connecting element 1 springs back to its initial position.

Fig. 2 shows again in perspective lip-shaped elements of the snap connection system according to the invention, in these figures the parts corresponding to the parts of Fig. 1 being indicated by the same reference numbers, but provided with an apostrophe.

In Fig. 2 the connecting element 1' provided with a lobe 3', again composed of a bendable lip, is fixed to, for example, a cover of a housing for an electrical installation, while the lip 2' with the catch part 4' is fixed by one end to the housing of the electrical installation. Unlike the embodiment of Fig. 1, the lip-shaped connecting elements 1', 2' are fitted here in such a way relative to each other that they lie in line with each other. The connecting element 1' is resiliently bendable in the direction of the arrow B', while the connecting element 2' is resiliently bendable in the direction C' (see Fig. 2d). Fig. 2a shows the situation in which the cover and the housing are detached from each other and the connecting elements 1' and 2' are in their non-working position. When the cover to which the connecting element 1' is fixed is being fitted, the connecting element 1' is moved in the direction of the arrow A' towards the connecting element 2', in which case the catch part 4' of the connecting element 2' comes to rest against the lobe part 3' and by means of the slanting surface 3'a of said lobe part bends the connecting element 1' in the direction of the arrow B' until the lobe part 3' has moved past the catch part 4', following which the lobe part slots behind the catch part 4' and the catch part 4' comes to lie against the body of the connecting element 1', as shown in Fig. 2c. The connecting elements are thus situated in the locked position here. As shown in Fig. 3, the body of the connecting element 1' against which the catch part 4' of the connecting element 2' comes to rest has in cross-section a bevelled part 5', while the edge of the catch part 4' lying against it has a complementary slanting part 6'. If the cover with the connecting element 1' is to be removed from the housing, the connecting element 2' is first bent in the direction of the arrow C', in which case, due to the fact that the bevelled parts 5' of the body of the connecting element 1' and 6' of the edge of the lobe element 4' lying against it slide along each other, the connecting element 1' is bent away in the direction of the arrow B' until the catch element 4' is moved entirely under the connecting element 1' and lies clear of the lobe part 3', in which situation the connecting element 1' is resiliently moved back in the direction of the arrow Bv', and comes to rest with its bottom side 1'a against the top side 4'a of the catch part 4', as a result of which the connecting element 2' is blocked in the unlocked position by the connecting element 1', as shown in Fig. 2d, until the lobe part 3' on movement of the connecting element 1' in the direction of the arrow Av' lies totally clear of the catch part 4', following which the connecting element 2' bends back resiliently to its initial position, as shown in Fig. 2a.

Fig. 4a shows a snap connection system, of which a lip-shaped connecting element with a lobe 3 is of the same embodiment as that shown in Figs. 1a - 1d. This connecting element is fixed by its end facing away from the lobe 3 to a cover, of which two side walls 7 and 8, standing at right angles to each other, are shown. The cover is provided with a slit-shaped aperture 9, the purpose of which will be explained further below. The connecting element 1 extends with the resilient body thereof along one wall of the aperture 9 and is hingedly connected by the end facing away from the lobe part 3 to the closed top side (not shown) of the cover. A connecting element 2'' with a catch part 4'' interacts with the connecting element 1, 3 provided in the cover, in the manner indicated with reference to Figures 1a - 1d. It is pointed out that the catch part 4'' is directed exactly opposite to the body part 2'' compared with the catch part 4 relative to the body part 1 in Figs. 1a - 1d, but this does not produce any difference at all in the working of the two embodiments. The connecting element 2'' is fitted, in a manner not indicated in any further detail, in a cabinet which can be shut off, and of which two walls 10 and 11, standing at right angles to each other, are shown. The connecting elements 1, 3 and 2'', 4'' are situated in such a way that when the cover 7, 8 is fitted on the cabinet 10, 11 in the direction of the arrow A' the connecting elements go into the locked position with their lobe part 3 and 4'', in the manner discussed above, as shown in Fig. 4b. In order to release the locked position, in the embodiment according to Figs. 4a - 4b, the body 2'' has to be bent away in the direction of the arrow C''. For this, the slit 9 is provided in the cover, into which slit a screwdriver can be inserted for bending away the element 2''. The connecting element 2'' is provided at its side facing the aperture 9 with a plate-shaped element 12, which is provided on the outside with a lobe element 13 which in the locked position projects into the aperture. The plate-shaped element is designed in such a way that in the locked position shown in Fig. 4b it completely seals the aperture 9 in the cover on the inside, so that no impurities can penetrate into the cabinet and the interior of the cabinet is not readily accessible. The catch 13 is provided so that a screwdriver can be used on it for bending away the connecting element 2'' for unlocking the cover.

It is pointed out that in the embodiment according to Figs. 2a -2d also a slit-shaped aperture in the cover for unlocking by means of a screwdriver can be sealed directly via the front face 4'b of the catch part 4' of the connecting element 2' facing the aperture. The lobe part can be provided with a lobe element 13' for the engagement of a screwdriver.

It is pointed out that the invention is not restricted to the examples of embodiments shown, but that the invention also extends to modified embodiments which fall within the scope of the invention as described in the claims.

## Claims

1. Snap connection system for detachably connecting a detachable part of an assembly to a fixed part thereof, in particular for detachably fixing a cover on a housing for electrical installations, which connection system contains at least one set of connecting elements, of which one is fitted on the detachable part of the assembly, and the other on the fixed part, and one being provided with a lobe part and the other with a catch part interacting therewith to produce a connection, the connecting element provided with a lobe part being movable resiliently in one direction and being rigid in the directions at right angles thereto, all this in such a way that during the fitting of the detachable part on the fixed part of the assembly the connecting element provided with a lobe part is moved away in its resilient direction of movement by the connecting element provided with a catch part, through movement of the lobe part along the catch part and is then moved back resiliently into the locked position after the lobe part has been moved until it is past the catch part, characterized in that the connecting element provided with the catch part is also movable resiliently in a direction at right angles to the direction in which the connecting element provided with the lobe part is movable and in the directions at right angles thereto is rigid, in such a way that the connecting element provided with the catch part is movable resiliently from a locked position, in which the catch part is locked with the lobe part of the connecting element provided with the lobe part, to an unlocked position in which the catch part lies totally clear of the lobe part, while provisions are made for blocking the connecting element provided with the catch part in the unlocked position thereof by the connecting element provided with the lobe part, until the latter element is removed from the former element, the connecting elements being rigid in the approaching and receding direction of the element provided with the lobe part.

2. Connection system according to Claim 1, characterized in that the catch part of one connecting element and the face of the body of the other connecting element against which said catch part lies in the locked position of the connecting elements are formed and/or positioned in such a way that when there is a resilient movement of the catch part from the locked position, the connecting element provided with the lobe part is moved resiliently in the direction away from the connecting element provided with the catch part, and in the fully unlocked position of the catch part moves back again resiliently to a position in which it blocks the connecting element provided with the catch part in the unlocked position.

3. Connection system according to Claim 2, characterized in that the connecting elements are lip-shaped and are composed of resilient, bendable material, the lip-shaped elements each being fixed by one end to the part of the assembly in which they are fitted, and the element connected to the detachable part of the assembly at the free, bendable end thereof being provided with a lobe part, while the element connected to the fixed part at the bendable end thereof is provided with a catch part, the ends of the connecting elements provided with the lobe part and the catch part facing each other, and the lips being disposed in such a way that said ends are resiliently bendable in directions at right angles to each other and are not bendable in the directions at right angles thereto.

4. Connection system according to Claim 3, characterized in that the lip-shaped connecting elements are positioned essentially with their lengthwise directions at right angles to each other, in such a way that the connecting element provided with the catch part and disposed in the fixed part of the assembly is rigid in the approaching and receding direction of the connecting element provided with the lobe part, and the connecting element provided with the lobe part and fitted in the detachable part of the assembly is rigid in the resilient bending direction of the connecting element provided with the catch part.

5. Connection system according to Claim 3, characterized in that the lip-shaped elements lie essentially with their lengthwise direction both in line with each other and in the approaching and receding direction of the connecting elements, while the connecting element provided with the catch part and fitted in the fixed part of the assembly is bendable in a plane parallel to the plane in which the longitudinal axis of the connecting element provided with the lobe part extends, and the connecting element provided with the lobe part is rigid in that bending direction.

6. Connection system according to Claim 4 and/or 5, characterized in that the catch part of the connecting element provided with the catch part and the surface of the body of the connecting element provided with the lobe part against which the catch part lies in the locked position are at least partially bevelled, in such a way that on bending of the connecting element provided with the catch part in the transverse direction of the connecting element provided with the lobe part the connecting element provided with the lobe part is bent away.

7. Connection system according to any of the preceding claims, wherein the detachable part, i.e. the cover of the assembly, is provided with an aperture for insertion through it of a tool for releasing the locked position of any two interacting connecting elements, characterized in that the connecting element provided with the catch part fitted in the fixed part, i.e. in the housing of the assembly, is provided with an element for sealing off the cover aperture belonging thereto in the locked position of the connecting elements.

## Patentansprüche

1. Schnappverbindungssystem zur lösbaren Befestigung eines lösbaren Teiles einer Anordnung an einem mit dieser fest verbundenen Teil, insbesondere zur lösbare Befestigung einer Abdeckung auf einem Gehäuse für elektrische Anlagen, mit mindestens einem Satz von Verbindungselementen, von dem ein Element an dem lösbaren Teil der Anordnung angebracht ist, und das andere an dem festen Teil, und eines mit einer Nase versehen ist und das andere mit einer Klinke, die mit der Nase zur Erzeugung einer Verbindung zusammenarbeitet, wobei sich das mit einer Nase versehene Verbindungselement in einer Richtung federnd bewegen kann und in den dazu senkrechten Richtungen starr ist, derart daß während der Anbringung des lösbaren Teils auf dem festen Teil der Anordnung das mit einer Nase versehene Verbindungselement durch das mit einer Klinke versehene Verbindungselement in seiner federnden Bewegungsrichtung weggedrückt wird, solange sich die Nase entlang der Klinke bewegt, und sich dann federnd in seine Sperrposition zurückbewegt, nachdem die Nase die Klinke passiert hat, dadurch gekennzeichnet, daß das mit einer Klinke versehene Verbindungselement ebenfalls in einer Richtung senkrecht zu der Richtung federnd beweglich ist, in der das mit einer Nase versehene Verbindungselement beweglich ist, und es in den dazu rechtwinklig stehenden Richtungen starr ist, derart daß das mit einer Nase versehene Verbindungselement federnd von einer Sperrposition, in der die Klinke mit der Nase des mit einer Nase versehenen Verbindungselementes verriegelt ist, in eine entriegelte Position, in der die Klinke keinen Kontakt mit de Nase hat, bewegt werden kann, während dafür gesorgt ist, daß das mit einer Klinke versehene Verbindungselement durch das mit einer Nase versehene Verbindungselement in seiner entriegelten Position gehalten wird, bis letzteres Element von ersterem entfernt wurde, wobei die Verbindungselemente in der Einführungs- und der Entfernungsrichtung des mit einer Nase versehenen Verbindungselemente starr sind.

2. Verbindungssystem nach Anspruch 1, dadurch gekennzeichnet, daß die Klinke des einen Verbindungselements und die Körperoberfläche des anderen Verbindungselements, an der die Klinke in der Sperrposition der Verbindungselemente anliegt, eine solche Form und/oder Position haben, daß sich bei einer federnden Bewegung der Klinke aus der Sperrposition das mit einer Nase versehene Verbindungselement federnd von dem mit einer Klinke versehenen Verbindungselement wegbewegt, und es sich in der vollständig entriegelten Position der Klinke wieder federnd in eine Position zurückbewegt, in der es das mit einer Klinke versehene Verbindungselement in der entriegelten Position festhält.

3. Verbindungssystem nach Anspruch 2, dadurch gekennzeichnet, daß die Verbindungselemente lippenförmig und aus federndem, biegsamen Material aufgebaut sind, wobei jedes lippenförmige Element mit einem Ende an dem zugehörigen Teil der Anordnung befestigt ist, wobei das mit dem lösbaren Teil der Anordnung verbundene Element an seinem freien, biegsamen Ende mit einer Nase versehen ist, während das mit dem festen Teil verbundene Element an seinem biegsamen Ende mit einer Klinke versehen ist, und die Enden der mit einer Nase und mit einer Klinke versehen Verbindungselemente einander zugewendet sind, und die Lippen in einer Weise angeordnet sind, daß die Enden federnd in zueinander rechtwinkligen Richtungen zu bewegen sind, aber nicht in zu diesen Richtungen rechtwinkligen Richtungen.

4. Verbindungssystem nach Anspruch 3, dadurch gekennzeichnet, daß die lippenförmigen Verbindungselemente mit ihren Längsachsen in wesentlichen zueinander rechtwinklig angeordnet sind, derart daß das mit einer Klinke versehene und am festen Teil der Anordnung angebrachte Verbindungselement in der Einführungs- und der Entfernungsrichtung des mit einer Nase versehenen Verbindungselementes starr ist, und das mit einer Nase versehene und am lösbaren Teil der Anordnung angebrachte Verbindungselement in der Richtung, in der das mit einer Klinke versehene Verbindungselement federnd zu biegen ist, starr ist.

5. Verbindungssystem nach Anspruch 3, dadurch gekennzeichnet, daß die lippenförmigen Verbindungselemente mit ihren Längsachsen im wesentlichen auf einer Achse und in der Einführungs- und der Entfernungsrichtung der Verbindungselemente liegen, hingegen das mit einer Klinke versehene und am festen Teil der Gesamtanordnung angebrachte Verbindungselement in einer parallel zu der Ebene liegenden Ebene, in welcher sich die Längsachse des mit einer Nase versehenen Verbindungselementes erstreckt, biegsam ist, und das mit einer Nase versehenen Verbindungselement in dieser Biegerichtung starr ist.

6. Verbindungssystem nach Anspruch 4 und/oder 5, dadurch gekennzeichnet, daß die Klinke des mit der Klinke versehenen Verbindungselementes und die Körperoberfläche des mit der Nase versehenen Verbindungselementes, an der die Klinke in der Sperrposition anliegt, zumindest teilweise abgeschrägt ist derart daß, wenn man das mit einer Klinke versehenen Verbindungselementes in einer Richtung quer zu dem mit einer Nase versehenen Verbindungselement bewegt, das mit einer Nase versehene Verbindungselement weggebogen wird.

7. Verbindungssystem nach einem der vorhergehenden Ansprüche, bei dem das lösbare Teil, d.h. die Abdeckung der Anordnung, mit einer Öffnung versehen ist, durch die ein Werkzeug zur Entriegelung der Sperrposition von zwei beliebigen zusammenarbeitenden Verbindungselementen eingeführt werden kann, dadurch gekennzeichnet, daß das mit einer Klinke versehene und am festen Teil, d.h. dem Gehäuse der Gesamtanordnung angebrachte Verbindungselement, mit einem Element zum Verschliessen der zugehörigen Öffnung in der Abdeckung in der Sperrposition der Verbindungselemente versehen ist.

## Revendications

1. Système de liaison encliquetable pour relier d'une manière amovible une partie amovible d'un ensemble à une partie fixe de celui-ci, en particulier pour fixer d'une manière amovible un capot sur un coffret pour installations électriques, lequel système de liaison comporte au moins un jeu d'éléments de liaison, dont l'un est monté sur la partie amovible de l'ensemble, et l'autre sur la partie fixe, et l'un étant pourvu d'une partie formant patte et l'autre d'une partie formant cliquet coopérant avec cette patte pour réaliser une liaison, l'élément de liaison pourvu d'une partie formant patte étant déplaçable par élasticité dans un sens et étant rigide dans les directions perpendiculaires à ce sens, tout cela de telle façon que, pendant la mise en place de la partie amovible sur la partie fixe de l'ensemble, l'élément de liaison pourvu d'une partie formant patte soit écarté dans le sens de son déplacement par élasticité par l'élément de liaison pourvu d'une partie formant cliquet, grâce au mouvement de la partie formant patte le long de la partie formant cliquet, puis revienne par élasticité dans la position verrouillée après que la partie formant patte s'est déplacée jusqu'à avoir dépassé la partie formant cliquet, caractérisé en ce que l'élément de liaison pourvu de la partie formant cliquet est également déplaçable par élasticité dans une direction perpendiculaire au sens dans lequel l'élément de liaison pourvu d'une partie formant patte est déplaçable et est rigide dans les directions perpendiculaires à ce sens, de telle façon que l'élément de liaison pourvu de la partie formant cliquet soit déplaçable par élasticité depuis une position verrouillée, dans laquelle la partie formant cliquet est verrouillée avec la partie formant patte de l'élément de liaison pourvu de la partie formant patte, jusqu'à une position déverrouillée dans laquelle la partie formant cliquet est complètement dégagée de la partie formant patte, tandis que des moyens sont prévus pour bloquer en position verrouillée l'élément de liaison pourvu de la partie formant cliquet à l'aide de l'élément de liaison pourvu de la partie formant patte, jusqu'à ce que le second élément soit dégagé du premier élément, les éléments de liaison étant rigides dans le sens de l'approche et du recul de l'élément pourvu de la partie formant patte.

2. Système de liaison selon la revendication 1, caractérisé en ce que la partie formant cliquet de l'élément de liaison et la face du corps de l'autre élément de liaison contre laquelle ladite partie formant cliquet se trouve dans la position verrouillée des éléments de liaison sont formées et/ou placée de façon que lorsqu'il y a un déplacement élastique de la partie formant cliquet depuis la position verrouillée, l'élément de liaison pourvu de la partie formant patte s'écarte par élasticité de l'élément de liaison pourvu de la partie formant cliquet, et, dans la position entièrement déverrouillée de la partie formant cliquet, il revient par élasticité dans une position dans laquelle il bloque dans la position déverrouillée l'élément de liaison pourvu de la partie formant cliquet.

3. Système de liaison selon la revendication 2, caractérisé en ce que les éléments de liaison sont en forme de lèvres et sont en matière élastique pouvant fléchir, les éléments en forme de lèvres étant fixés chacun par une extrémité à la partie de l'ensemble dans laquelle ils sont montés, et l'élément relié à la partie amovible de l'ensemble comportant à son extrémité libre apte à fléchir une partie formant patte, tandis que l'élément relié à la partie fixe comportant à son extrémité apte à fléchir une partie formant cliquet, les extrémités des éléments de liaison comportant la partie formant patte et la partie formant cliquet étant mutuellement en regard, et les lèvres étant disposées de façon que lesdites extrémités puissent fléchir par élasticité dans des directions mutuellement perpendiculaires et ne puissent pas fléchir dans les directions perpendiculaires à celles-ci.

4. Système de liaison selon la revendication 3, caractérisé en ce que les éléments de liaison en forme de lèvres sont placés avec leurs sens longitudinaux sensiblement perpendiculaires l'un à l'autre, de façon que l'élément de liaison comportant la partie formant cliquet et disposé dans la partie fixe de l'ensemble soit rigide dans le sens de l'approche et du recul de l'élément de liaison comportant la partie formant patte, et que l'élément de liaison comportant la partie formant patte et monté dans la partie amovible de l'ensemble soit rigide dans le sens de fléchissement élastique de l'élément de liaison comportant la partie formant cliquet.

5. Système de liaison selon la revendication 3, caractérisé en ce que les éléments en forme de lèvres sont placés avec leurs sens longitudinaux sensiblement alignés l'un avec l'autre et dans le sens de l'approche et du recul des éléments de liaison des éléments de liaison, tandis que l'élément de liaison comportant la partie formant cliquet et installé dans la partie fixe de l'ensemble est apte à fléchir dans un plan parallèle au plan dans lequel s'étend l'axe longitudinal de l'élément de liaison comportant la partie formant patte, et que l'élément de liaison comportant la partie formant patte est rigide dans ce sens de fléchissement.

6. Système de liaison selon la revendication 4 et/ou 5, caractérisé en ce que la partie formant cliquet de l'élément de liaison comportant la partie formant cliquet et la surface du corps de l'élément de liaison comportant la partie formant patte contre laquelle la partie formant cliquet se trouve dans la position verrouillée sont au moins partiellement biseautées, de façon qu'au moment du fléchissement de l'élément de liaison comportant la partie formant cliquet dans le sens transversal de l'élément de liaison comportant la partie formant patte, l'élément de liaison comportant la partie formant patte s'écarte par fléchissement.

7. Système de liaison selon l'une quelconque des revendications précédentes, dans lequel la partie amovible, c'est-à-dire le capot de l'ensemble, comporte un orifice à travers lequel peut être introduit un outil pour supprimer la position verrouillée de n'importe quelle paire d'éléments de liaison en coopération mutuelle, caractérisé en ce que l'élément de liaison comportant la partie formant cliquet installée dans la partie fixe, c'est-à-dire dans le coffret de l'ensemble, comporte un élément pour interdire l'accès à l'orifice du capot appartenant à celui-ci dans la position verrouillée des éléments de liaison.
